# EUROPEAN PATENT APPLICATION

(11) **EP 4 783 166 A1**
(43) Date of publication of application: **29.07.2026**
(21) Application number: 26151207.3
(22) Date of filing: 11.01.2026
(51) Int. Cl.: G11C 5/02, H10B 41/10, H10B 43/10, H10B 43/27

(54) **MEMORY DEVICE AND METHOD OF MANUFACTURING A MEMORY DEVICE**

(30) Priority: 23.01.2025 CN 202510111843
(71) Applicant: Wuhan Xinxin Semiconductor Manufacturing Co., Ltd., Wuhan, Hubei 430205 (CN)
(72) Inventor: CAO, Kaiwei, Wuhan, 430205 (CN)
(74) Representative: De Arpe Tejero, Manuel

(57) **Abstract**

A memory device including a memory array and a method of manufacturing a memory device are provided. The memory array includes memory cells disposed in an array having multiple rows and multiple columns and a source line. Each memory cell includes a substrate, a gate structure in the substrate, a source, and a drain. The source and the drain are disposed on two sides of the gate structure along a first direction. The memory array defines a source lead-out region that includes a source contact line extending along the first direction. The source contact line is connected to common sources distributed along the first direction. Each common source is connected to the sources in a same row along a second direction perpendicular to the first direction. The source line is disposed on the source contact line, extends along the second direction, and is connected to the source contact line.

## Description

### TECHNICAL FIELD

The present disclosure relates, but is not limited, to the field of semiconductor technology, and more particularly, to a memory device and a method of manufacturing a memory device.

### BACKGROUND

In an application of integrated circuits, a performance of various devices, especially a memory device, may be affected by a spacing between different material layers as the spacing between these layers influences a metal routing of the devices.

During operations in practice, the Research & Development team of the present disclosure has observed that in current semiconductor device manufacturing solutions, especially in the manufacturing of the current memory device, a back-end-of-line (BEOL) process of forming gate structures has high precision requirements for metal routing. The leading and connection manners for the gate structures, sources, and drains, as well as an arrangement of corresponding bit lines, word lines, and source lines, are relatively complex. In this way, any improper design may affect an arrangement of the memory array and a layout of peripheral circuits, rendering a layout density difficult to be improved and further affecting the performance of the memory array.

### SUMMARY OF THE DISCLOSURE

In a first aspect, some embodiments of the present disclosure may provide a memory device. The memory device may include a memory array and a source line. The memory array may include a plurality of memory cells. The memory cells may be disposed in an array having multiple rows and multiple columns. Each of the memory cells may include a substrate, a gate structure disposed in the substrate, a source, and a drain. The source and the drain may be disposed on two sides of the gate structure along a first direction. The memory array may define a source lead-out region. The source lead-out region may include a source contact line extending along the first direction. The source contact line may be connected to a plurality of common sources distributed along the first direction. Each of the plurality of common sources may be connected to the sources in a same row along a second direction. The source line may be disposed on the source contact line. The source line may extend along the second direction and be connected to the source contact line. The first direction and the second direction may be perpendicular to each other.

In a second aspect, some embodiments of the present disclosure may provide a method of manufacturing a memory device. The method may include forming a memory array. The memory array may include a plurality of memory cells disposed in an array having multiple rows and multiple columns. Each of the memory cells may include a substrate, a gate structure disposed in the substrate, a source, and a drain. The source and the drain may be disposed on two sides of the gate structure along a first direction. The memory array may define a source lead-out region. The source lead-out region may include a source contact line extending along the first direction. The source contact line may be connected to a plurality of common sources distributed along the first direction. Each of the plurality of common sources may be connected to the sources in a same row along a second direction. The method may further include forming a source line. The source line may be disposed on the source contact line. The source line may extend along the second direction and be connected to the source contact line. The first direction and the second direction may be perpendicular to each other.

Different from the related art, some embodiments of the present disclosure may provide a memory device. The memory device may include a plurality of memory cells and a source line. The memory cells may be disposed in an array having multiple rows and multiple columns. Each of the memory cells may include a substrate, a gate structure disposed in the substrate, a source, and a drain. The source and the drain may be disposed on two sides of the gate structure along a first direction. The memory array may define a source lead-out region. The source lead-out region may include a source contact line extending along the first direction. The source contact line may be connected to a plurality of common sources distributed along the first direction. Each of the plurality of common sources may be connected to the sources in a same row along a second direction. The source line may be disposed on the source contact line. The source line may extend along the second direction and be connected to the source contact line. The first direction and the second direction may be perpendicular to each other. In other words, in some embodiments of the present disclosure, the plurality of sources in the same row along the second direction may be connected through a corresponding one of the common sources. The source contact line may be connected to the common sources distributed along a first direction, such that the source line may be connected to the sources of the memory array through the source contact line. The source line and the source contact line may be substantially perpendicular to each other and be disposed at different planes, such that the sources in the memory array may be led out and connected together. Through reasonably arranging the wiring layers, layout density may be improved, thereby enhancing the performance of the memory array.

### BRIEF DESCRIPTION OF THE DRAWINGS

To illustrate the technical solutions in some embodiments of the present disclosure more clearly, the following will briefly introduce the accompanying drawings required for describing the embodiments. Obviously, the drawings in the following description are merely for some embodiments of the present disclosure. For those skilled in the art, other drawings may be derived from these drawings without creative effort.
FIG. 1 is a first perspective three-dimensional view of some embodiments of a memory device according to the present disclosure.
FIG. 2 is a second perspective three-dimensional view of some embodiments of a memory device according to the present disclosure.
FIG. 3 is a top view of some embodiments of a memory device according to the present disclosure.
FIG. 4 is a schematic structural view of some embodiments of a memory cell along a second direction according to the present disclosure.
FIG. 5 is a schematic structural view of some embodiments of a memory cell along a first direction according to the present disclosure.
FIG. 6 is a top view of some embodiments of forming a first sub-interlayer dielectric layer according to the present disclosure.
FIG. 7 is a top view of some embodiments of forming bit lines according to the present disclosure.
FIG. 8 is a top view of some embodiments of forming a word line and a source line according to the present disclosure.
FIG. 9 is a flowchart of some embodiments of a method of manufacturing a memory device according to the present disclosure.

In the figures: 110, substrate; 120, gate structure; 130, source; 140, drain; 200, interlayer dielectric layer; 201, first sub-interlayer dielectric layer; 202, second sub-interlayer dielectric layer; 310, gate contact structure; 311, first sub-gate contact structure; 312, second sub-gate contact structure; 313, third sub-gate contact structure; 320, source contact structure; 321, first sub-source contact structure; 322, source contact line; 323, second sub-source contact structure; 330, drain contact structure; 400, common source; 500, lead-out line; WL, word line; BL, bit line; SL, source line; A, lead-out region; B, memory region; C, source lead-out region; D, drain lead-out region.

### DETAILED DESCRIPTION

The technical solutions in some embodiments of the present disclosure will be described clearly and completely below in conjunction with the accompanying drawings. Obviously, the described embodiments represent only some embodiments of the present disclosure, rather than all possible embodiments. All other embodiments obtained by those skilled in the art based on the embodiments herein without creative effort shall fall within the scope of the present disclosure.

In current memory device manufacturing processes, especially for the manufacturing of the current memory device, a continuous advancement in a back-end-of-line (BEOL) manufacturing process may lead to progressive scaling down of memory device dimensions. In this way, an interconnect layout within the memory device gradually leads to a bottleneck that restricts layout density, thereby affecting the performance of the memory array.

Accordingly, some embodiments of the present disclosure may provide a memory device. The memory device may include a memory array. The memory array may include a plurality of memory cells. A plurality of sources in the same row along a second direction may be connected through a corresponding one of common sources. A source contact line may be connected to the common sources distributed along a first direction, such that a source line may be connected to the sources of the memory array through the source contact line. The source line and the source contact line may be substantially perpendicular to each other and be disposed at different planes, such that the sources in the memory array may be led out and connected together. Through reasonably arranging the wiring layers, layout density may be improved, thereby enhancing the performance of the memory array.

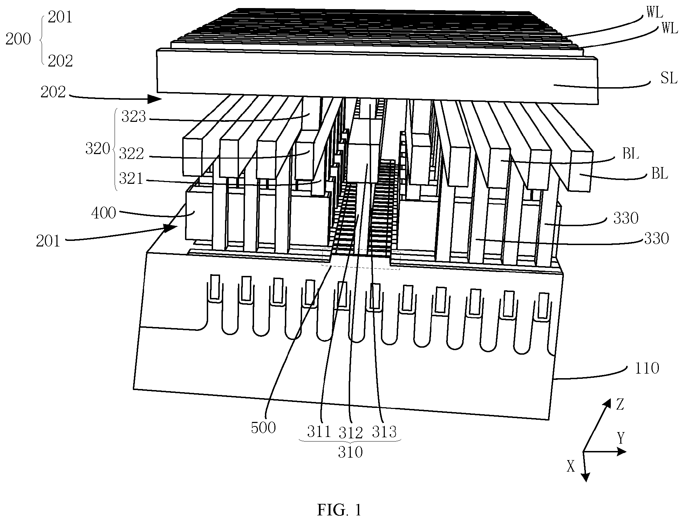

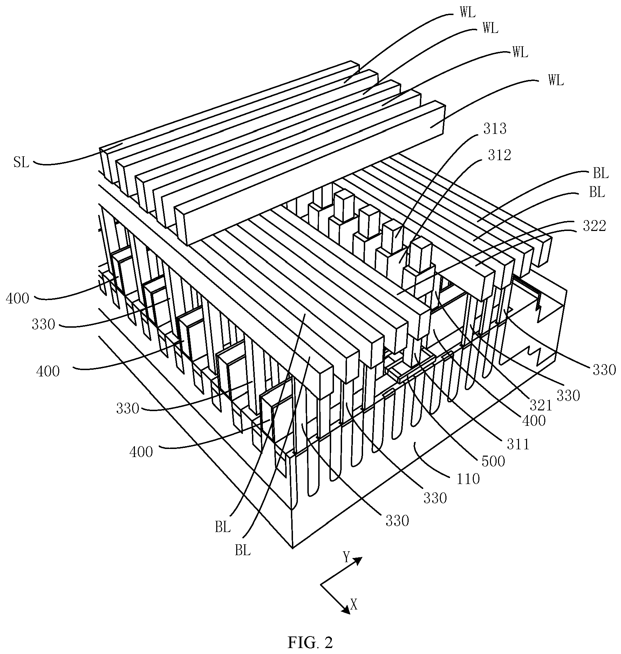

As shown in FIG. 1 and FIG. 2, FIG. 1 is a first perspective three-dimensional view of some embodiments of a memory device according to the present disclosure and FIG. 2 is a second perspective three-dimensional view of some embodiments of a memory device according to the present disclosure.

As shown in FIG. 1 and FIG. 2, the memory device of some embodiments of the present disclosure may include a memory array. The memory array may include a plurality of memory cells. The plurality of memory cells may be disposed in an array having multiple rows and multiple columns. Each memory cell may include a substrate, a gate structure (not labeled in the figures) disposed in the substrate, a source (not labeled in the figures), and a drain (not labeled in the figures). The source and the drain may be disposed on two side of the gate structure along a first direction. The memory array may define a source lead-out region C. The source lead-out region C may include a source contact line 322 extending along the first direction. The source contact line 322 may be connected to a plurality of common sources 400 distributed along the first direction. Each common source 400 may be connected to the sources in the same row along a second direction. A source line SL may be disposed on the source contact line 322. The source line SL may extend along the second direction and be connected to the source contact line 322, The first direction and the second direction may be perpendicular to each other.

In some embodiments, the first direction may correspond to a direction X and the second direction may correspond to a direction Y. The first direction and the second direction may be perpendicular to each other in a horizontal plane.

In some embodiments, above the array of multiple rows and multiple columns formed by the plurality of memory cells, the common sources 400 may be disposed at the source lead-out region C. The common sources 400 may be configured to connect the sources in the same row along the second direction. Further, the source contact line 322 may be formed on the plurality of common sources 400 in the source lead-out region C. The source contact line 322 may extend along the first direction and be connected to the plurality of common sources 400 distributed along the first direction.

In some embodiments, the memory array may further define the memory region B. Each memory region B may further be divided into the source lead-out region C and a drain lead-out region D.

It may be understood that two memory cells may share one source. The shared sources of memory cells in two rows along the second direction may be connected together through the common source 400. That is, each memory region B may include multiple corresponding common sources 400.

As further shown in FIG. 1 and FIG. 2, the source lead-out region C may include a plurality of first sub-source contact structures 321. Each first sub-source contact structures 321 may be connected to a corresponding one of the common sources 400. The first sub-source contact structures 321 in the same column along the first direction may be connected to the same source contact line 322.

The source lead-out region C may further include a second sub-source contact structure 323. The second sub-source contact structure 323 may be configured to lead out the source contact line 322, such that the source line SL may be connected to the source contact line 322 through the second sub-source contact structure 323.

It may be understood that the source contact line 322 may be disposed on a first plane and the source line SL may be disposed on a second plane. The source contact line 322 may extend along the first direction. The source line SL may extend along the second direction. The source contact line 322 and the source line SL may be substantially perpendicular to each other.

In the above embodiments, the source line and the source contact line may be substantially perpendicular to each other and may be disposed on different planes, thereby leading out the sources in the memory array and connecting the sources together. Through reasonably arranging the wiring layers, layout density may be improved, thereby enhancing the performance of the memory array.

In some embodiments, the memory array may include more than one memory region B. Each memory region B may correspond to one lead-out region A. The source contact line 322 may be disposed in each memory region B. The source contact line 322 may be disposed in the source lead-out region C of the memory region B.

In some embodiments, the memory device may further include a plurality of bit lines BL and a plurality of word lines WL. The plurality of bit lines BL may be disposed on the substrate. Each bit line BL may extend along the first direction and may be connected to the drains in the same column along the first direction. The plurality of word lines WL may be disposed on the substrate. Each word line WL may extend along the second direction and may be connected to the gate structures 120 in the same row along the second direction.

The plurality of bit lines BL may be disposed on the first plane and the plurality of word lines WL may be disposed on the second plane. The second plane may be higher than the first plane. The plurality of bit lines BL and the source contact line 322 may be disposed on the same plane. The plurality of word lines WL and the source line SL may be disposed on the same plane.

Further, the drain lead-out region D may include a plurality of drain contact structures 330. Each drain contact structure 330 may be connected to a corresponding one of the drains 140. The drain contact structures 330 in the same column along the first direction may be connected to the same bit line BL. That is, each bit line BL may be connected to the drains in the same column along the first direction through the drain contact structures 330.

Further, the memory array may define the lead-out region A. The lead-out region A may include a plurality of lead-out lines 500 and a plurality of gate contact structures 310. The plurality of lead-out lines 500 may be disposed in the lead-out region A. Each lead-out line 500 may be connected to the gate structures in the same row along the second direction. Each gate contact structure 310 may be connected to a corresponding one of the lead-out lines 500. That is, each gate contact structure 310 may be connected to the gate structures 120 in the same row along the second direction through the corresponding lead-out line 500. In other words, the gate structures 120 in the same row along the second direction of the same memory region B may be connected together through the lead-out lines 500 and may further be led out through the gate contact structure 310 of the lead-out region A, such that each word line WL may be connected to the gate structures 120 in the same row along the second direction through the gate contact structure 310.

In the above embodiments, the gate structures, the sources, and the drains may be led out. Correspondingly, each bit line may be connected to the drains in the same column along the first direction. Each word line may be connected to the gate structures in the same row along the second direction. Each source line may be connected to the sources of the memory array. The bit lines and the word lines may be disposed on different planes. The source line and the word lines may be disposed on the same plane. The wiring of the memory array may be reasonably arranged through setting metal layers corresponding to the two planes of the bit lines and the word lines. As a result, the layout density may be improved, thereby enhancing the performance of the memory device.

The following provides a further description of the memory device.

In order to more clearly illustrate the memory device, the memory device may be described in the form of a top view.

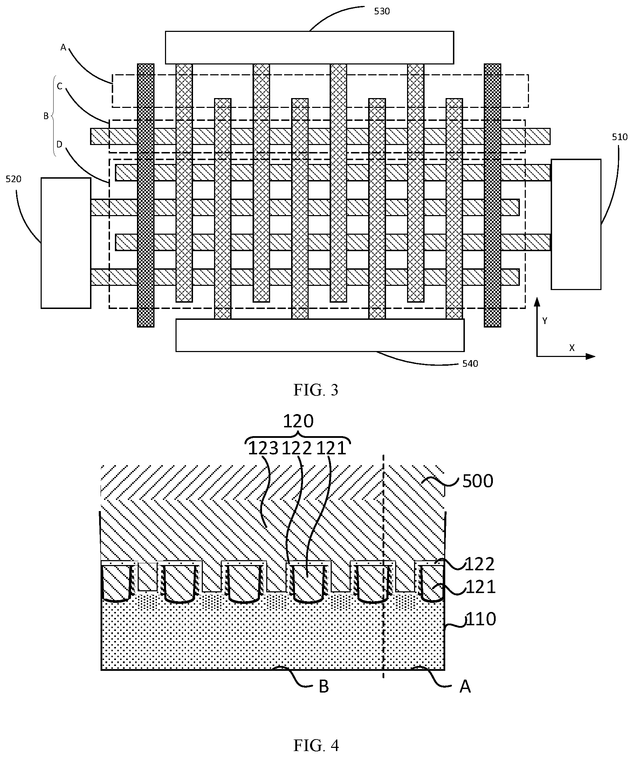

As shown in FIG. 3, FIG. 3 is a top view of some embodiments of a memory device according to the present disclosure.

As shown in FIG. 3, the memory array may be divided into the lead-out region A and the memory region B. The memory region B may be further divided into the source lead-out region C and the drain lead-out region D.

In some embodiments, the memory array may define the memory region B and the lead-out region A. The memory region B may be divided into the source lead-out region C and the drain lead-out region D. The common sources (not labeled in the figures) may be led out through source contact structures of the source lead-out region C, such that the source line SL may be connected to the common sources (not labeled in the figures) disposed along the first direction through the source contact structure (not labeled in the figures). The drains may be led out through the drain contact structures (not labeled in the figures) in the drain lead-out region D, such that the bit line BL may be connected to the drains (not labeled in the figures) disposed along the first direction through the drain contact structures (not labeled in the figures). The gate structures (not labeled in the figures) disposed along the second direction may be connected together and may be led out through the gate contact structures (not labeled in the figures) in the lead-out region A, such that the word lines WL may be connected to the gate structures (not labeled in the figures) disposed along the second direction through the gate contact structures 310.

In some embodiments, odd ones of the bit lines and even ones of the bit lines may be respectively connected to bit line peripheral circuits at two sides along the first direction. Odd ones of the word lines and even ones of the word lines may be respectively connected to word line peripheral circuits at two sides along the second direction.

As further shown in FIG. 3, the bit line peripheral circuits may include a first bit line peripheral circuit 510 and a second bit line peripheral circuit 520. The word line peripheral circuits may include a first word line peripheral circuit 530 and a second word line peripheral circuit 540. In this way, the odd ones of the bit lines BL may be connected to the first bit line peripheral circuit 510. The even ones of the bit lines BL may be connected to the second bit line peripheral circuit 520. The odd ones of the word lines WL may be connected to the first word line peripheral circuit 530. The even ones of the word lines WL may be connected to the second word line peripheral circuit 540.

It may be understood that the bit line peripheral circuits and the word line peripheral circuits may be circuits connected to the memory array, such as decoding circuits.

In some embodiments, each memory cell may be described. Each memory cell may include the substrate 110, the gate structure 120 formed in the substrate 100, the source, and the drain. The source and the drain may be disposed on two sides of the gate structure 120 along the first direction.

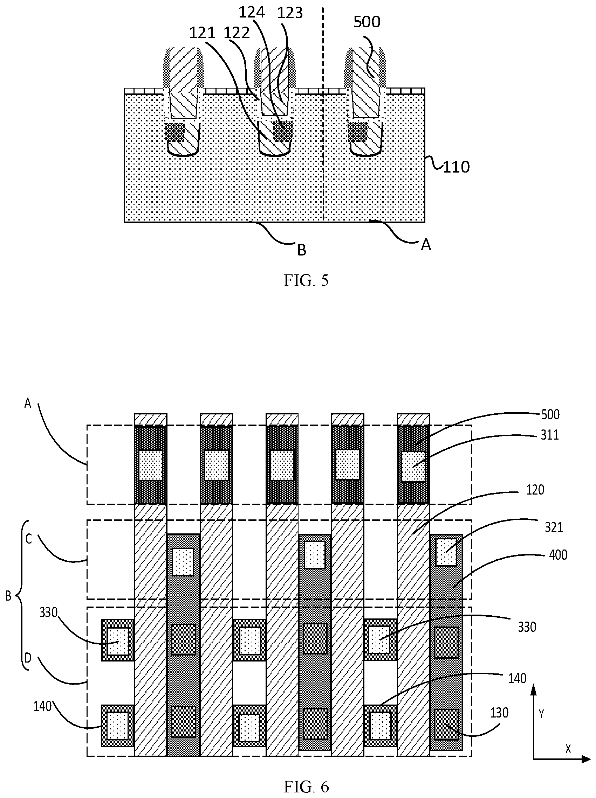

As shown in FIGS. 4 and 5, FIG. 4 is a schematic structural view of some embodiments of a memory cell along a second direction according to the present disclosure, and FIG. 5 is a schematic structural view of some embodiments of a memory cell along a first direction according to the present disclosure.

As shown in FIG. 4, along the second direction, the memory cell may be divided into the lead-out region A and the memory region B. The gate structure 120 may be formed in the substrate 110. The gate structures 120 in the memory region B and the lead-out lines 500 of the lead-out region A may be connected together, such that the lead-out lines 500 may be connected to the gate structures along the second direction. The gate structure 120 of the memory region B may be disposed in the substrate. The lead-out lines 500 of the lead-out region A may at least partially be exposed from the substrate 110, such that the subsequent gate contact structures (not labeled in the figures) may be connected to the lead-out lines 500.

In some embodiments, the gate structure 120 may include a first gate 121, a gate dielectric layer 122, a control gate 123, and a second gate 124. In the above embodiments, the first gate 121 and the second gate 124 may form a semi-floating gate structure. The gate structure 120 may be configured to form a semi-floating gate transistor. The gate structures 120 in the same row along the second direction may be connected together through the corresponding lead-out line 500 of the lead-out region A.

As shown in FIG. 5, along the first direction, the gate structure 120 may be formed in the substrate 110. The gate structure 120 may include the first gate 121, the gate dielectric layer 122, the control gate 123, and the second gate 124. The source (not shown in the figure) and the drain (not shown in the figure) may respectively be formed at two sides of the gate structure 120. The gate structure 120 of the memory region B may be disposed in the substrate 110. The lead-out lines 500 of the lead-out region A may be exposed from the substrate 110, facilitating the lead-out lines 500 to be connected to the subsequently formed gate contact structures.

It may be understood that the gate structure 120 in FIGS. 4 and 5 is merely an example of the gate structure. The gate structure may be configured according to actual requirements. The memory cell of the present disclosure may not be limited to the semi-floating gate transistor.

In some embodiments, the memory array may include more than one memory cell. Each memory cell may include the substrate 110, the gate structure 120 formed in the substrate 100, the source 130, and the drain 140. The source 130 and the drain 140 may be disposed on two sides of the gate structure 120 along the first direction. The memory array may be divided into the lead-out region A and the memory region B. Each memory region B may be configured with one lead-out region A. Each memory region B may include more than one gate structure 120. Each gate structure 120 may be configured with a corresponding source 130 and a corresponding drain 140. Along the second direction, the gate structures in the same memory region may be connected to the same gate contact structure through the lead-out line of the lead-out region A.

The interlayer dielectric layer may be formed on the substrate 110. The drain contact structures 330, the gate contact structures 310, and the source contact structure 320 may be formed in the interlayer dielectric layer, to lead out the drains 140, the gate structures 120, and the sources 130, respectively. The common sources 400 may further be formed in the interlayer dielectric layer. The source contact structure 320 may be connected to the sources 130 in the same row through the common sources 400. The drain contact structures 330 corresponding to the drains 140 may be connected to the bit lines BL in the drain lead-out region D. The gate contact structures 310 corresponding to the gate structures 120 may be connected to the word lines WL in the lead-out region A. The drain contact structures 330 and the gate contact structures 310 may extend to different planes. The source contact structure 320 corresponding to the sources may extend to the plane where the word lines WL are disposed in the source lead-out region C and may be connected to the source line SL. The source contact structure 320 may include first sub-source contact structures 321, the source contact line 322, and a second sub-source contact structure 323. The gate contact structures 310 may include a first sub-gate contact structure 311, a second sub-gate contact structure 312, and a third sub-gate contact structure 313.

The substrate may be any suitable substrate known in the art, for example, may include at least one of the following materials: silicon (Si), germanium (Ge), silicon germanium (SiGe), silicon carbide (SiC), silicon germanium carbide (SiGeC), indium arsenide (InAs), gallium arsenide (GaAs), indium phosphide (InP), or other III/V compound semiconductors, as well as multilayer structures composed of these semiconductors, or silicon-on-insulator (SOI), stacked silicon-on-insulator (SSOI), stacked silicon germanium-on-insulator (S-SiGeOI), silicon germanium-on-insulator (SiGeOI), and germanium-on-insulator (GeOI). The interlayer dielectric layer may be an interlayer dielectric (ILD), which may serve to protect the substrate and to isolate components.

In some embodiments, the gate contact structures 310, the source contact structure 320, and the drain contact structures 330 may include a conductive material, such as tungsten (W).

In some embodiments, the interlayer dielectric layer 200 may include a first sub-interlayer dielectric layer 201 and a second sub-interlayer dielectric layer 202. The first sub-interlayer dielectric layer may be formed on the substrate 110. The second sub-interlayer dielectric layer 202 may be formed on the first sub-interlayer dielectric layer 201.

A description of the first sub-interlayer dielectric layer will be provided first.

As shown in FIG. 6, FIG. 6 is a top view of some embodiments of forming a first sub-interlayer dielectric layer according to the present disclosure.

As shown in FIG. 6, the memory array may be divided into a lead-out region A and a memory region B. The memory region B may be further divided into the source lead-out region C and the drain lead-out region D. The drain contact structures 330, the common sources 400, the first sub-source contact structures 321, and first sub-gate contact structures 311 may be formed in the first sub-interlayer dielectric layer.

The drain contact structures 330 may be disposed in the drain lead-out region D. Each drain contact structure 330 may be connected to a corresponding one of the drains 140. The first sub-source contact structures 321 may be disposed in the source lead-out region C. Each first sub-source contact structure 321 may be connected to a corresponding one of the common sources 400. Each common source 400 may be connected to multiple sources 130 in the same row. Multiple common sources 400 may be disposed at intervals along the first direction. The first sub-gate contact structures 311 may be disposed in the lead-out region A. Each first sub-gate contact structure 311 may be connected to a corresponding one of the lead-out lines 500 in the lead-out region A. Each lead-out line 500 may be connected to multiple gate structures 120 in the same row. The lead-out lines 500 may be disposed at intervals along the first direction.

Next, the bit lines may be formed on the first sub-interlayer dielectric layer.

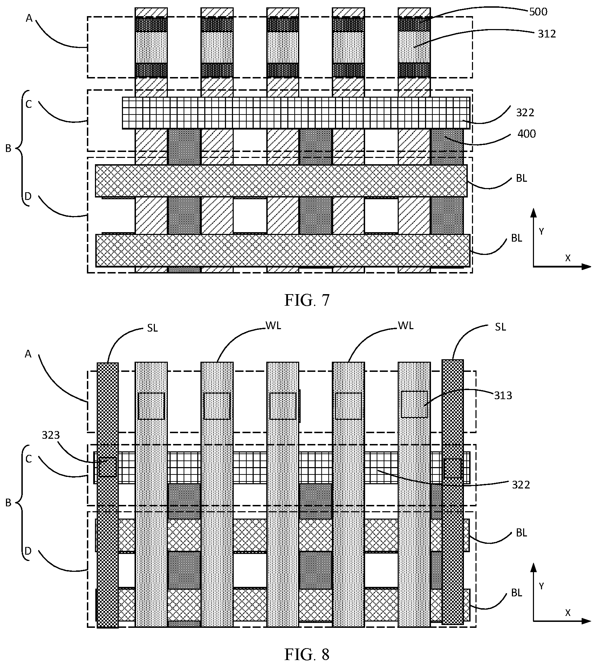

As shown in FIG. 7, FIG. 7 is a top view of some embodiments of forming bit lines according to the present disclosure.

As shown in FIG. 7, based on FIG. 6, multiple bit lines BL may be formed in the drain lead-out region D. The multiple bit lines BL may be spaced apart from each other along the second direction. Each bit line BL may extend along the first direction and may be connected to multiple drain contact structures (not labeled in the figures) in the same column along the first direction, such that each bit line BL may be connected to multiple drains (not labeled in the figures) in the same column along the first direction through the drain contact structures.

Further, the source contact line 322 may be formed in the source lead-out region C. The source contact line 322 may extend along the first direction and may be substantially parallel to the bit lines BL. The source contact line 322 may be connected to multiple first sub-source contact structures (not labeled in the figures) in the first direction, such that the source contact line 322 may be connected to the multiple common sources 400 through the multiple first sub-source contact structures.

Further, in the lead-out region A, the second sub-gate contact structures 312 may be formed above the first sub-gate contact structures (not labeled in the figures), such that each second sub-gate contact structure 312 may be connected to a corresponding one of the first sub-gate contact structures 311. The second sub-gate contact structures 312 may be disposed on the same plane as both the bit lines BL and the source contact line 322, namely on the first plane.

In some embodiments, an area of the second sub-gate contact structure 312 may be greater than an area of the first sub-gate contact structure 311.

Then, the second sub-interlayer dielectric layer may be formed, and the second sub-source contact structure 323 and the third sub-gate contact structure 313 may be formed in the second sub-interlayer dielectric layer, thereby forming the source line SL and the word lines WL.

As shown in FIG. 8, FIG. 8 is a top view of some embodiments of forming a word line and a source line according to the present disclosure.

As shown in FIG. 8, based on FIG. 7, the second sub-interlayer dielectric layer may be formed. That is, the second sub-interlayer dielectric layer may be configured to cover the bit lines BL, the source contact line 322, and the second sub-gate contact structures 312. The second sub-source contact structure 323 and the multiple third sub-gate contact structures 313 may further be formed in the second sub-interlayer dielectric layer.

The second sub-source contact structure 323 may be disposed in the source lead-out region C and may be connected to the source contact line 322. The third sub-gate contact structures 313 may be disposed in the lead-out region A. Each third sub-gate contact structure 313 may be connected to a corresponding one of the second sub-gate contact structure (not labeled in the figures) so as to lead out the multiple gate structures in the same row along the second direction.

The source line SL and multiple word lines WL may thus be formed. Each word line WL may extend along the second direction, with the word lines WL being arranged parallel to each other along the first direction.

It may be understood that the source line SL and the multiple word lines WL may be disposed on the second plane. That is, the second plane may be located above the second sub-interlayer dielectric layer. The first plane may be located above the first sub-interlayer dielectric layer. The first sub-interlayer dielectric layer may cover the substrate. The second sub-interlayer dielectric layer may cover the first plane.

The source line SL may extend along the second direction and may be connected to the source contact line 322 through the second sub-source contact structure 323. Each word line WL may be connected to the gate structures in the same row along the second direction through a corresponding one of the gate contact structures 310.

It may be understood that the bit lines BL may be located at the first plane. The source line SL and the word lines WL may be located at the same plane. That is, the source line SL and the word lines WL may be located at the second plane. The source line SL may further extend along the second direction. The first sub-interlayer dielectric layer may cover the substrate. The first plane may be located above the first sub-interlayer dielectric layer. The second sub-interlayer dielectric layer may cover the first plane. The second plane may be located above the second sub-interlayer dielectric layer.

In the above embodiments, multiple sources in the same row along the second direction may be connected through the common sources. The source contact line may be configured to connect multiple common sources distributed along the first direction, such that the source line may be connected to the sources of the memory array through the source contact line. The source line and the source contact line may be substantially perpendicular to each other. The source line and the source contact line may be located at different planes. In this way, the sources in the memory array may be led out and connected to each other, reasonably arranging the wiring layers, improving layout density, and thereby enhancing the performance of the memory device.

Some embodiments of the present disclosure may further provide a method of manufacturing a memory device.

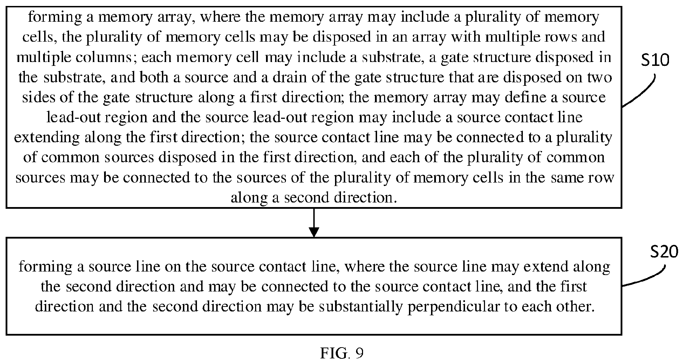

As shown in FIG. 9, FIG. 9 is a flowchart of some embodiments of a method of manufacturing a memory device according to the present disclosure.

As shown in FIG. 9, the method of manufacturing a memory device may include the following operation.

At operation S10: forming a memory array. The memory array may include a plurality of memory cells. The plurality of memory cells may be disposed in an array having multiple rows and multiple columns. Each memory cell may include a substrate, a gate structure disposed in the substrate, a source, and a drain. The source and the drain may be disposed on two sides of the gate structure along a first direction. The memory array may define a source lead-out region. The source lead-out region may include a source contact line extending along the first direction. The source contact line may be connected to a plurality of common sources distributed in the first direction. Each of the plurality of common sources may be connected to the sources of the plurality of memory cells in the same row along a second direction.

In some embodiments, the first direction may correspond to a direction X and the second direction may correspond to a direction Y. The first direction and the second direction may be perpendicular to each other.

In some embodiments, the substrate may be provided. The plurality of memory cells may be formed on the substrate. The plurality of memory cells may further be arranged into the memory array having multiple rows and multiple columns. Each memory cell may include the substrate 110, the gate structure 120 disposed in the substrate 110, the source 130, and the drain 140. The common sources 400 may be formed on the sources 130. Each common source 400 may be connected to the sources 130 in the same row along the second direction. The source contact line 322 may be formed in the source lead-out region C. The source contact line 322 may extend along the first direction. The source contact line 322 may be connected to the common sources 400 distributed in the first direction. The memory array may be divided into the lead-out region A and the memory region B. The memory region B may further be divided into the source lead-out region C and the drain lead-out region D.

At operation S20: forming a source line on the source contact line. The source line may extend along the second direction and may be connected to the source contact line. The first direction and the second direction may be substantially perpendicular to each other.

In some embodiments, the source line SL extending along the second direction may be formed on the substrate 110. The source line SL may be connected to the source contact line, so that the source line SL may be connected to the plurality of common sources 400 through the source contact line 322.

In the above embodiments, the plurality of common sources in the same memory region along the second direction may be led out through the same source contact line, which may effectively reduce wiring complexity, reduce the chance of interference, enable reasonable configuration of wiring layers, improve layout density, and thereby improve the performance of the memory array.

In order to more clearly illustrate the structure of the memory device, the following describes the formation process of the memory device in combination with the accompanying drawings.

First, the substrate 110 may be formed. The substrate 110 may include the gate structure 120, the source 130, and the drain 140. The source 130 and the drain 140 may be disposed at two sides of the gate structure 120 along the first direction. The lead-out lines 500 may be configured to connect the gate structures in the same row along the second direction to each other. Then, the interlayer dielectric layer 200 may be formed. The contact structures may be formed in the interlayer dielectric layer 200 to lead out the drains 140, the gate structures 120, and the sources 130, respectively. The drain contact structures 330 corresponding to the drains 130 may be connected to the bit lines BL. The gate contact structures 310 corresponding to the gate structures 120 may be connected to the word lines WL. The drain contact structures 330 and the gate contact structures 310 may extend to different planes. The source contact structure 320 corresponding to the sources 130 may extend to a plane corresponding to the word line WL, so that the source contact structure 320 may be connected to the source line.

The substrate 110 may first be provided. Further, the gate structures 120, the sources 130, and the drains 140 may be formed in the substrate 110.

In some embodiments, the substrate 110 may be provided. The gate structures 120 may be formed in the substrate 110. The sources 130 and the drains 140 may be formed at two sides of the gate structures 120 along the first direction, as shown in FIGS. 4 and 5. The specific structure and manufacturing process of the memory array may be referred to Chinese patent application No. 202311044576.3.

The memory array may be divided into the memory region B and the lead-out region A. The gate structures 120 may be formed in the substrate 110. The sources 130 and the drains 140 may be formed at two sides of the gate structures 120 along the first direction. The sources 130 and the drains 140 may be disposed in the memory region B. The lead-out lines 500 of the lead-out region A may be exposed from the substrate. The lead-out lines 500 may be connected to the gate structures 120 in the same row along the second direction.

In some embodiments, a shallow trench isolation structure may further be formed in the substrate, so as to define a plurality of active areas (AA) in the substrate. The gate structures 120, the sources 130, and the drains 140 may then be formed in the corresponding active areas.

In some embodiments, before forming a plurality of bit lines, the method may further include the following operations.

The common sources 400 may be formed. The common sources 400 may be disposed in the memory region A on the substrate 110. The common sources 400 may be configured to connect the sources 130 in the same memory region B along the second direction to each other.

Further, the first sub-gate contact structures 311 may be formed on the lead-out lines 500. The first sub-source contact structures 321 may be formed on the common sources 400. The drain contact structures 330 may be formed on the drains 140.

In some embodiments, after the common source 400 is formed, the method may further include the following operations. The first sub-source contact structures 321 may be formed in the source lead-out region C. Each first sub-source contact structure 321 may be connected to a corresponding one of the common sources 400. The source contact line 322 may be formed. The first sub-source contact structures 321 in the same column along the first direction may be connected to the same source contact line 322. The second sub-source contact structure 323 may be formed in the source lead-out region C, such that the source line SL may be connected to the source contact line 322 through the second sub-source contact structure 323.

In some embodiments, the method may further include: forming a plurality of bit lines BL on the substrate 110. Each bit line BL may extend along the first direction and may be connected to the drains 140 in the same column along the first direction. The word lines WL may be formed on the substrate 110. Each word line WL may extend along the second direction and may be connected to the gate structures 120 in the same row along the second direction. The bit lines BL may be located at the first plane. The word lines WL may be located at the second plane. The second plane may be higher than the first plane.

In some embodiments, the method may further include: defining a drain lead-out region D in the memory array. The plurality of drain contact structures 330 may be formed in the drain lead-out region D. Each drain contact structure 330 may be connected to a corresponding one drain 140. The drain contact structures 330 in the same column along the first direction may be connected to the same bit line BL.

In some embodiments, the memory array may further define the lead-out region A. The plurality of lead-out lines 500 may be disposed in the lead-out region A. Each lead-out line 500 may connect the gate structures 120 in the same row along the second direction. The gate contact structures 310 may be formed in the lead-out region A. Each word line WL may be connected to a corresponding one lead-out line 500 through a corresponding one gate contact structure 310.

In some embodiments, the interlayer dielectric layer may further be formed. The method may include the following operations.

The interlayer dielectric layer may be formed. The drain contact structures 330, the gate contact structures 310, and the source contact structures 320 may be formed in the interlayer dielectric layer.

The interlayer dielectric layer may include the first sub-interlayer dielectric layer and the second sub-interlayer dielectric layer. The source contact structure 320 may include the first sub-source contact structures 321, the source contact line 322, and the second sub-source contact structure 323. The gate contact structure 310 may include the first sub-gate contact structure 311, the second sub-gate contact structure 312, and the third sub-gate contact structure 313.

In some embodiments, the first sub-interlayer dielectric layer may first be formed. The drain contact structures 330, the first sub-source contact structure 321, and the first sub-gate contact structure 311 may be formed in the first sub-interlayer dielectric layer. Each first sub-source contact structure 321 may be configured to lead out the sources 130 in the same row along the second direction through the corresponding common source 400. Each drain contact structure 330 may be configured to lead out a corresponding drain 140. The first sub-gate contact structures 311 may be configured to lead out the gate structures 120 in the same row along the second direction through the lead-out lines 500, as shown in FIG. 6.

The substrate 110 may be divided into the lead-out region A and the memory region B. The memory region B may be divided into the source lead-out region C and the drain lead-out region D. The first direction may be defined as the direction X and the second direction may be defined as the direction Y. In this way, the first sub-gate contact structures 311 may be disposed in the lead-out region A and may be spaced apart from each other along the first direction. The first sub-source contact structures 321 may be disposed in the source lead-out region C and may be spaced apart from each other along the first direction. The drain contact structures 330 may be disposed in the drain lead-out region D and may be spaced apart from each other along both the first direction and the second direction.

Next, the plurality of bit lines BL may be formed. That is, the bit lines BL may be formed on the first sub-interlayer dielectric layer and may extend along the first direction. Each bit line BL may be connected to the drains 140 in the same column along the first direction through the corresponding drain contact structure 330. The source contact line 322 may further be formed. That is, the source contact line 322 may be formed on the first sub-interlayer dielectric layer and may extend along the first direction. The source contact line 322 may be connected to the common sources 400 in the same column along the first direction through the first sub-source contact structures 321. The plurality of second sub-gate contact structures 312 may further be formed. That is, the second sub-gate contact structures 312 may be formed on the first sub-interlayer dielectric layer. Each second sub-gate contact structure 312 may be connected to a corresponding one first sub-gate contact structure 311, as shown in FIG. 7.

It may be understood that each memory region B may include one source contact line 322. The source contact line 322 and the bit lines BL may be disposed at the first plane and arranged substantially parallel to each other.

Next, the second sub-interlayer dielectric layer may be formed.

In some embodiments, the second sub-interlayer dielectric layer may be formed. The second sub-source contact structure 323 and the third sub-gate contact structures 313 may be formed in the second sub-interlayer dielectric layer. The second sub-source contact structure 323 may be connected to the first sub-source contact structures 321 in the same column along the first direction through the source contact line 322. Each third sub-gate contact structure 313 may be connected to a corresponding one second sub-gate contact structure 312.

The third sub-gate contact structures 313 may be disposed in the lead-out region A and may be connected to the second sub-gate contact structures 312. That is, each gate contact structure 310 may be divided into three parts, including the first sub-gate contact structure 311 disposed in the first sub-interlayer dielectric layer, the second sub-gate contact structure 312 disposed at the first plane above the first sub-interlayer dielectric layer, and the third sub-gate contact structure 313 disposed in the second sub-interlayer dielectric layer.

After the second sub-interlayer dielectric layer is formed. The source line SL and the word lines WL may be formed. The source line SL may be connected to the source contact line 322 through the second sub-source contact structure 323. The word lines WL may be connected to the gate structures in the same row along the second direction through the gate contact structures 310.

In some embodiments, the source line SL may extend along the second direction and may be connected to the source contact line 322. The source line SL and the word lines WL may be located at the second plane and may be arranged substantially parallel to each other.

By arranging two metal layers in two planes respectively corresponding to the bit lines and the word lines, the wiring of the memory array may be reasonably configured, the layout of peripheral circuits may be facilitated, the layout density may be improved, and the performance of the memory device may thereby be enhanced.

In some embodiments, along the first direction, the odd ones of the bit lines and the even ones of the bit lines may be connected to the bit line peripheral circuits at two sides, respectively. Along the second direction, the odd ones of the word lines and the even ones of the word lines may be connected to the word line peripheral circuits at two sides, respectively.

The bit lines may be disposed at the first plane and the word lines may be disposed at the second plane. A distance from the first plane to the substrate may be smaller than a distance from the second plane to the substrate. That is, the first plane may be closer to the substrate.

In the above embodiments, the sources in the same row along the second direction may be connected together through the corresponding common source. The common sources in the same column along the first direction may be led out through the same source contact line. The source line may be configured to be connected to the source contact line. The source line and the source contact line may be substantially perpendicular to each other and may be disposed in different planes. The sources in the memory array may thereby be led out and connected together, which may effectively reduce wiring complexity, reduce the chance of interference, reasonably configure wiring layers, improve layout density, and thereby improve the performance of the memory array.

The foregoing description may merely be illustrative embodiments of the present disclosure, and shall not be construed as limiting the scope of the present disclosure. Any equivalent structures or equivalent process transformations made using the specification and the drawings of the present disclosure, or direct or indirect applications in other related technical fields, may similarly fall within the protection scope of the present disclosure.

## Claims

1. A memory device, **characterized by** comprising:
a memory array, comprising:
a plurality of memory cells, disposed in an array having multiple rows and multiple columns, wherein each of the memory cells comprises a substrate (110), a gate structure (120) disposed in the substrate (110), a source (130), and a drain (140); the source (130) and the drain (140) are disposed on two sides of the gate structure (120) along a first direction;
wherein the memory array defines a source lead-out region (C), the source lead-out region (C) comprises a source contact line (322) extending along the first direction, the source contact line (322) is connected to a plurality of common sources (400) distributed along the first direction, and each of the plurality of common sources (400) is connected to the sources (130) in a same row along a second direction; and
a source line (SL), disposed on the source contact line (322), extending along the second direction, and connected to the source contact line (322), wherein the first direction and the second direction are perpendicular to each other.

2. The memory device as claimed in claim 1, wherein the source lead-out region (C) comprises a plurality of first sub-source contact structures (321), each of the plurality of first sub-source contact structures (321) is connected to a corresponding one of the plurality of common sources (400), and the plurality of the first sub-source contact structures (321) in a same column along the first direction are connected to the same source contact line (322); and
wherein the source lead-out region (C) further comprises a second sub-source contact structure (323) and the source line (SL) is connected to the source contact line (322) through the second sub-source contact structure (323).

3. The memory device as claimed in claim 1, further comprising:
a plurality of bit lines (BL), disposed on the substrate (110), wherein each of the plurality of bit lines (BL) extends along the first direction and is connected to the drains (140) in a same column along the first direction; and
a plurality of word lines (WL), disposed on the substrate (110), wherein each of the plurality of word lines (WL) extends along the second direction and is connected to the gate structures (120) in a same row along the second direction;
wherein the plurality of bit lines (BL) are disposed on a first plane, the plurality of word lines (WL) are disposed on a second plane, and the second plane is higher than the first plane.

4. The memory device as claimed in claim 3, wherein the plurality of bit lines (BL) and the source contact line (322) are disposed on a same plane and the plurality of word lines (WL) and the source line (SL) are disposed on a same plane.

5. The memory device as claimed in claim 3, wherein the memory array further defines a drain lead-out region (D); and
the drain lead-out region (D) comprises a plurality of drain contact structures (330), each of the plurality of drain contact structures (330) is connected to a corresponding one of the drains (140) and the plurality of drain contact structures (330) on a same column along the first direction is connected to a same one of the plurality of bit lines (BL).

6. The memory device as claimed in claim 3, wherein the memory array further defines a lead-out region (A); and
the lead-out region (A) further comprises:
a plurality of lead-out lines (500), disposed in the lead-out region (A), wherein each of the lead-out lines (500) is connected to the gate structures (120) in a same row along the second direction; and
a plurality of gate contact structures (310), each of the plurality of word lines (WL) is connected to a corresponding one of the plurality of lead-out lines (500) through one of the plurality of gate contact structures (310).

7. The memory device as claimed in claim 3, wherein odd ones of the plurality of bit lines (BL) and even ones of the plurality of bit lines (BL) are respectively connected to bit line peripheral circuits (510, 520) at two sides along the first direction; and
odd ones of the plurality of word lines (WL) and even ones of the plurality of word lines (WL) are respectively connected to word line peripheral circuits (530, 540) at two sides along the second direction.

8. The memory device as claimed in claim 1, further comprising:
an interlayer dielectric layer (200), disposed on the substrate (110), wherein drain contact structures (330), gate contact structures (310), and a source contact structure (320) are formed in the interlayer dielectric layer (200) and are respectively connected to the drains (140), the gate structures (120), and the sources (130);
wherein the drain contact structures (330) extend to a first plane and are connected to a plurality of bit lines (BL), the gate contact structures (310) extend to a second plane and are connected to a plurality of word lines (WL), and the source contact structure (320) extend to the second plane and are connected to the source line (SL).

9. The memory device as claimed in claim 8, wherein the source contact structure (320) further comprises first sub-source contact structures (321), the source contact line (322), and a second sub-source contact structure (323), and each of the gate contact structures (310) comprise a first sub-gate contact structure (311), a second sub-gate contact structure (312), and a third sub-gate contact structure (313); and
wherein the interlayer dielectric layer (200) comprises:
a first sub-interlayer dielectric layer (201), formed on the substrate (110), wherein the drain contact structures (330), the first sub-source contact structures (321), and the first sub-gate contact structures (311) are formed in the first sub-interlayer dielectric layer (201); and the plurality of bit lines (BL), the source contact line (322), and the second sub-gate contact structures (312) are formed on the first sub-interlayer dielectric layer (201); and
a second sub-interlayer dielectric layer (202), formed on the first sub-interlayer dielectric layer (201), wherein the second sub-source contact structure (323) and the third sub-gate contact structures (313) are formed in the second sub-interlayer dielectric layer (202);
wherein the drains (140) in a same column along the first direction are connected to a same one of the plurality of bit lines (BL) through the corresponding drain contact structures (330), and the gate structures (120) in a same row along the second direction are connected to a same one of the plurality of word lines (WL) through a same one of the gate contact structures (310).

10. A method of manufacturing a memory device, comprising:
forming a memory array, wherein the memory array comprises:
a plurality of memory cells, disposed in an array having multiple rows and multiple columns, wherein each of the memory cells comprises a substrate (110), a gate structure (120) disposed in the substrate (110), a source (130), and a drain (140); the source (130) and the drain (140) are disposed on two sides of the gate structure (120) along a first direction;
wherein the memory array defines a source lead-out region (C), the source lead-out region (C) comprises a source contact line (322) extending along the first direction, the source contact line (322) is connected to a plurality of common sources (400) distributed along the first direction, and each of the plurality of common sources (400) is connected to the sources (130) in a same row along a second direction; and
forming a source line (SL), wherein the source line (SL) is disposed on the source contact line (322), extends along the second direction, and is connected to the source contact line (322);
wherein the first direction and the second direction are perpendicular to each other.

11. The method as claimed in claim 10, wherein after forming the plurality of common sources (400), the method further comprises:
forming a plurality of first sub-source contact structures (321) in the source lead-out region (C), wherein each of the first sub-source contact structures (321) is connected to a corresponding one of the common sources (400);
forming the source contact line (322), wherein the plurality of the first sub-source contact structures (321) in a same column along the first direction are connected to the same source contact line (322); and
forming a second sub-source contact structure (323) in the source lead-out region (C), enabling the source line (SL) to be connected to the source contact line (322) through the second sub-source contact structure (323).

12. The method as claimed in claim 10, further comprising:
forming a plurality of bit lines (BL) on the substrate (110), wherein each of the plurality of bit lines (BL) extends along the first direction and is connected to the drains (140) in a same column along the first direction; and
forming a plurality of word lines (WL) on the substrate (110), wherein each of the plurality of word lines (WL) extends along the second direction and is connected to the gate structures (120) in a same row along the second direction;
wherein the plurality of bit lines (BL) are disposed on a first plane, the plurality of word lines (WL) are disposed on a second plane, and the second plane is higher than the first plane.

13. The method as claimed in claim 12, wherein the plurality of bit lines and the source contact line are disposed on a same plane and the plurality of word lines and the source line are disposed on a same plane.

14. The method as claimed in claim 12, wherein the memory array further defines a drain lead-out region (D); and
the method further comprises:
forming a plurality of drain contact structures (330) in the drain lead-out region (D), wherein each of the plurality of drain contact structures (330) is connected to a corresponding one of the drains (140) and the plurality of drain contact structures (330) on a same column along the first direction is connected to a same one of the plurality of bit lines (BL).

15. The method as claimed in claim 12, wherein
the memory array further defines a lead-out region (A), a plurality of lead-out lines (500) are disposed in the lead-out region (A), each of the plurality of lead-out lines (500) is connected to the gate structures (120) in a same row along the second direction; and
the method further comprises:
forming a plurality of gate contact structures (310) in the lead-out region (A), wherein each of the plurality of word lines (WL) is connected to a corresponding one of the lead-out lines (500) through one of the plurality of gate contact structures (310).
